(19) **Europäisches Patentamt**
**European Patent Office**
**Office européen des brevets**

(11) **EP 3 327 431 B1**

(12) **EUROPÄISCHE PATENTSCHRIFT**

(45) Veröffentlichungstag und Bekanntmachung des Hinweises auf die Patenterteilung:
**11.01.2023 Patentblatt 2023/02**

(21) Anmeldenummer: **17201042.3**

(22) Anmeldetag: **10.11.2017**

(51) Internationale Patentklassifikation (IPC):
**G01N 27/02** *(2006.01)* **G01R 27/22** *(2006.01)*

(52) Gemeinsame Patentklassifikation (CPC):
**G01N 27/025; G01R 27/22**

(54) **INDUKTIVES LEITFÄHIGKEITSMESSGERÄT UND VERFAHREN ZUM BETREIBEN EINES INDUKTIVEN LEITFÄHIGKEITSMESSGERÄTS**

INDUCTIVE CONDUCTIVITY SENSOR AND METHOD FOR OPERATING AN INDUCTIVE CONDUCTIVITY SENSOR

APPAREIL DE MESURE DE CONDUCTIVITÉ INDUCTIF ET PROCÉDÉ DE FONCTIONNEMENT D'UN APPAREIL DE MESURE DE CONDUCTIVITÉ INDUCTIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.11.2016 DE 102016122800**

(43) Veröffentlichungstag der Anmeldung:
**30.05.2018 Patentblatt 2018/22**

(73) Patentinhaber: **Krohne Messtechnik GmbH**
**47058 Duisburg (DE)**

(72) Erfinder:
• **Glasmachers, Holger**
**44795 Bochum (DE)**
• **Mertmann, Philipp**
**44869 Bochum (DE)**

(74) Vertreter: **Gesthuysen Patentanwälte**
**Patentanwälte**
**Huyssenallee 100**
**45128 Essen (DE)**

(56) Entgegenhaltungen:
EP-A1- 0 975 956          DE-A1-102009 026 998
DE-B3-102016 104 549   US-A- 5 003 267
US-A1- 2009 267 617     US-A1- 2013 141 117

• **BUNYAK A M ET AL: "RESONANT LC CIRCUIT AS A CONTACTLESS CONDUCTOMETRIC CONVERTER", MEAS. TECH,, Bd. 17, Nr. 11, 1. April 1975 (1975-04-01) , Seiten 1764-1767, XP001322252,**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft zum einen ein Verfahren zum Betreiben eines induktiven Leitfähigkeitsmessgeräts. Das Leitfähigkeitsmessgerät weist zur Durchführung des Verfahrens eine elektrische Sendespule und eine elektrische Empfangsspule auf und die Sendespule weist wiederum einen elektrischen Eingang auf. Dabei sind die Sendespule und die Empfangsspule durch ein elektrisch leitfähiges Medium induktiv miteinander gekoppelt. Bei dem Verfahren wird ein elektrisches Vorgabewechselsignal erzeugt und dem Eingang der Sendespule zugeführt.

Die Erfindung betrifft zum anderen auch ein induktives Leitfähigkeitsmessgerät. Das Leitfähigkeitsmessgerät weist ebenfalls eine elektrische Sendespule, eine elektrische Empfangsspule und eine Steuerungseinrichtung u. a. zur Steuerung der Sendespule und der Empfangsspule auf. Die Sendespule weist wiederum einen elektrischen Eingang auf. Die Steuerungseinrichtung ist dabei zur Erzeugung von einem elektrischen Vorgabewechselsignal und zur Zuführung des Vorgabewechselsignals zum Eingang der Sendespule ausgebildet. Im Betrieb des induktiven Leitfähigkeitsmessgeräts sind die Sendespule und die Empfangsspule durch ein elektrisch leitfähiges Medium induktiv miteinander gekoppelt.

Induktive Leitfähigkeitsmessgeräte können auch in aggressiven und korrosiven Medien wie beispielsweise industriellen Abwässern, Meerwasser und sauren Lösungen eingesetzt werden. Das ist möglich, weil sowohl die Sendespule als auch die Empfangsspule im Gegensatz zu den Elektroden eines konduktiven Leitfähigkeitsmessgeräts nicht in unmittelbarem Kontakt mit einem Medium stehen müssen, sondern von einem gegen aggressive und korrosive Medien resistenten Gehäuse umgeben sein können, ohne dass die Funktionsfähigkeit eingeschränkt ist. Da bei Vorhandensein eines Gehäuses kein unmittelbarer Kontakt mit aggressiven und korrosiven Medien gegeben ist, zeichnen sich induktive Leitfähigkeitssensoren durch eine lange Lebensdauer und durch eine weitgehende Wartungsfreiheit im Vergleich zu konduktiven Leitfähigkeitsmessgeräten aus. Durch die Gehäuse sind sie darüber hinaus auch für hygienische Anwendungen in Prozessen der Branchen Lebensmittel, Getränke und Pharmaka geeignet.

Ein elektrischer Eingang einer elektrischen Spule wie zum Beispiel der Sendespule oder der Empfangsspule weist für gewöhnlich zwei elektrische Anschlüsse auf, über welche ein elektrisches Signal wie zum Beispiel das elektrische Vorgabewechselsignal in die Spule eingespeist wird. Die induktive Kopplung der Sendespule und der Empfangsspule miteinander über das elektrisch leitfähige Medium erfolgt, indem das in die Sendespule eingespeiste Vorgabewechselsignal in dem Medium Wirbelströme erzeugt und die Wirbelströme in der Empfangsspule ein Empfangswechselsignal zum Beispiel in Form einer Spannung induzieren. Somit bewirkt ein Vorgabewechselsignal ein Empfangswechselsignal.

Aus dem Stand der Technik ist bekannt, eine elektrische Leitfähigkeit eines Mediums aus dem Verhältnis einer Amplitude eines Empfangswechselsignals und einer Amplitude eines Vorgabewechselsignals zu bestimmen. Zur Bestimmung einer Amplitude eines Wechselsignals werden analoge elektronische Schaltungen wie z. B. analoge Lock-In-Verstärker verwendet. Problematisch bei der Bestimmung von Amplituden mit analogen elektronischen Schaltungen ist jedoch, dass die Genauigkeit der Bestimmung einer Amplitude und damit auch die Genauigkeit der Bestimmung einer Leitfähigkeit eines Mediums von der Genauigkeit der elektronischen Schaltung abhängt. Dabei wird die Genauigkeit einer analogen elektronischen Schaltung von Drifts und Toleranzen der Komponenten der elektronischen Schaltung beeinträchtigt.

Der Erfindung liegt daher die Aufgabe zugrunde, ein Verfahren zum Betreiben eines induktiven Leitfähigkeitsmessgeräts sowie ein induktives Leitfähigkeitsmessgerät anzugeben, bei dem die Genauigkeit einer Bestimmung einer Leitfähigkeit eines Mediums gegenüber dem Stand der Technik verbessert ist.

Die Erfindung bezieht sich gemäß einer ersten Lehre auf ein Verfahren zum Betreiben eines induktiven Leitfähigkeitsmessgeräts, bei dem die dargelegte Aufgabe gelöst ist. Das erfindungsgemäße Verfahren ist zunächst im Wesentlichen durch die folgenden Verfahrensschritte gekennzeichnet:
In einem ersten Verfahrensschritt wird eine Frequenz des Vorgabewechselsignals in einem Frequenzintervall variiert. Die Variation der Frequenz erfolgt somit innerhalb des Frequenzintervalls.

In einem zweiten Verfahrensschritt wird in diesem Frequenzintervall eine frequenzabhängige minimale Eingangsimpedanz am Eingang der Sendespule unter Verwendung eines Reaktionswechselsignals bestimmt. Dabei wird das Reaktionswechselsignal vom Vorgabewechselsignal durch die Sendespule bewirkt. Wenn z. B. das Vorgabewechselsignal eine Spannung über dem Eingang der Sendespule bewirkt und die Spannung somit ein Sendewechselsignal darstellt, dann ist das Reaktionswechselsignal ein durch die Spannung bewirkter Strom durch die Sendespule und umgekehrt. Die Eingangsimpedanz ist der Quotient aus der Spannung und dem Strom. Diesem Verfahrensschritt liegt die Erkenntnis zugrunde, dass die Eingangsimpedanz am Eingang der Sendespule eine frequenzabhängige Größe mit einem Realteil und einem Imaginärteil ist. Der Realteil wird auch als Resistanz und der Imaginärteil als Reaktanz bezeichnet. Der Betrag und die Phase der Eingangsimpedanz werden aus Resistanz und Reaktanz bestimmt und sind von der Frequenz des Vorgabewechselsignals abhängig, wobei die Frequenz des Vorgabewechselsignals und die Frequenz des Reaktionswechselsignals identisch sind. Die minimale Eingangsimpedanz ist dabei für gewöhnlich die Eingangsimpedanz mit dem geringsten Betrag der Eingangsimpedanz innerhalb des Frequenzintervalls. Zumeist werden der erste und der zweite Verfahrensschritt zusammen ausgeführt.

In einem dritten Verfahrensschritt wird eine Minimumfrequenz des Reaktionswechselsignals bei der minimalen Eingangsimpedanz am Eingang der Sendespule bestimmt. Die Minimumfrequenz ist dabei gerade die Frequenz des Reaktionswechselsignals und damit auch des Vorgabewechselsignals, bei dem die Eingangsimpedanz minimal ist.

In einem vierten Verfahrensschritt wird unter Verwendung der Minimumfrequenz des Reaktionswechselsignals eine Leitfähigkeit des Mediums bestimmt. Diesem Verfahrensschritt liegt die Erkenntnis zugrunde, dass die Minimumfrequenz eine Funktion der Leitfähigkeit des Mediums ist. Die Funktion wird zum Beispiel durch Ausführen des Verfahrens mit verschiedenen Medium bestimmt, wobei jedes der verschiedenen Medien eine andere bekannte Leitfähigkeit aufweist. Dabei hat sich gezeigt, dass die Empfindlichkeit, also eine Änderung der Minimumfrequenz in Bezug auf eine Änderung der Leitfähigkeit, außerhalb eines Leitfähigkeitsmessbereichs, der einen Dynamikbereich der Leitfähigkeit von ungefähr 100 umfasst, abnimmt. So ändert sich die Minimumfrequenz z. B. in einem Leitfähigkeitsbereich von 20mS/cm bis 2S/cm (2S/cm dividiert durch 20mS/cm ergibt 100) um den Faktor 2. Außerhalb dieses Leitfähigkeitsbereichs nimmt die Empfindlichkeit ab.

Das erfindungsgemäße Verfahren hat gegenüber dem aus dem Stand der Technik bekannten Verfahren den Vorteil, dass die Bestimmung der Leitfähigkeit des Mediums genauer ist. Die höhere Genauigkeit ergibt sich insbesondere daraus, dass keine Amplituden von Größen, sondern eine Frequenz von einem Wechselsignal bestimmt wird. Denn es hat sich gezeigt, dass bei gleichem technischen Aufwand und damit auch gleichen Kosten, die Bestimmung einer Frequenz genauer umsetzbar ist als die Bestimmung einer Amplitude.

In einer Ausgestaltung des erfindungsgemäßen Verfahrens zum Betreiben eines induktiven Leitfähigkeitsmessgeräts, bei welchem die Sendespule, die Empfangsspule und das Medium ein elektrischen Schwingkreis mit einer Resonanzfrequenz bilden, ist vorgesehen, dass bei der Bestimmung von der minimalen Eingangsimpedanz und der Minimumfrequenz die Resonanzfrequenz des Schwingkreises bestimmt wird. Dieser Ausgestaltung liegt die Erkenntnis zugrunde, dass die Sendespule, die Empfangsspule und das Medium zusammen einen Schwingkreis mit einer Resonanzfrequenz bilden. Dabei weisen die Sendespule, die Empfangsspule und das Medium die für einen Schwingkreis notwendigen induktiven und kapazitiven Komponenten auf. Weiterhin ist erkannt worden, dass eine Korrelation zwischen den induktiven Komponenten, welche die Resonanzfrequenz mitbestimmen, und der Leitfähigkeit des Mediums besteht. Somit ist aus der Resonanzfrequenz und auch aus der Eingangsimpedanz die Leitfähigkeit bestimmbar. Während die induktiven Komponenten der Sendespule und der Empfangsspule im Wesentlichen erwünschte Eigenschaften sind, sind die kapazitiven Komponenten im Wesentlichen unerwünschte Eigenschaften der Sendespule und der Empfangsspule. Aus dem Stand der Technik ist bekannt, kapazitive Eigenschaften, also parasitäre Kapazitäten, von Spulen zu minimieren, was dem erfindungsgemäßen Verfahren jedoch entgegensteht. Zusätzlich zu parasitären Kapazitäten werden z. B. auch Kondensatoren zur Realisierung des Schwingkreises und/oder zur Einstellung der Resonanzfrequenz des Schwingkreises vorgesehen. Die Resonanzfrequenz ist die Frequenz des Schwingkreises, bei der die Reaktanz der Eingangsimpedanz Null ist und die Eingangsimpedanz somit nur eine Resistanz aufweist. Folglich ist auch der Betrag der Eingangsimpedanz bei der Resonanzfrequenz minimal, weshalb die Resonanzfrequenz der Minimumfrequenz entspricht.

In einer weiteren Ausgestaltung des Verfahrens zum Betreiben eines induktiven Leitfähigkeitsmessgeräts, welches einen elektrischen Messwiderstand am Eingang der Sendespule aufweist, ist vorgesehen, dass als das Reaktionswechselsignal eine Messspannung über dem Messwiderstand gemessen wird. Alternativ dazu kann als das Reaktionswechselsignal ein Messstrom durch den Messwiderstand bestimmt werden. Der Messstrom wird z. B. aus der Messspannung und einem Widerstandswert des Messwiderstands bestimmt. Der Messwiderstand ist vorzugsweise elektrisch in Reihe mit dem Eingang der Sendespule verschaltet. Das bedeutet, dass, wenn keine weiteren Komponenten vorhanden sind, der gleiche Strom durch die Sendespule und den Messwiderstand fließt. In Kombination mit der vorstehenden Ausgestaltung wird die Resonanzfrequenz des Schwingkreises bestimmt, indem eine Maximalamplitude der Messspannung über den Messwiderstand in dem Frequenzintervall bestimmt wird. Denn bei der Maximalamplitude der Messspannung liegt die Resonanzfrequenz an, welche der Minimumfrequenz entspricht. Zur Bestimmung der Amplitude der Messspannung wird zum Beispiel ein analoger Lock-In-Verstärker verwendet. Bei dieser Verwendung eines analogen Lock-In-Verstärkers sind absolute Fehler bei der Bestimmung der Amplitude der Messspannung unerheblich, da die Maximalamplitude der Messspannung in Relation zum Verlauf der Amplitude der Messspannung über dem Frequenzintervall bestimmt wird.

Die Erfindung bezieht sich gemäß einer zweiten Lehre auf ein induktives Leitfähigkeitsmessgerät, bei dem die dargelegte Aufgabe gelöst ist. Das erfindungsgemäße induktive Leitfähigkeitsmessgerät ist zunächst im Wesentlichen dadurch gekennzeichnet, dass die Steuerungseinrichtung dazu ausgebildet ist, im Betrieb des induktiven Leitfähigkeitsmessgeräts eine Frequenz des Vorgabewechselsignals in einem Frequenzintervall zu variieren, in dem Frequenzintervall eine frequenzabhängige minimale Eingangsimpedanz am Eingang der Sendespule unter Verwendung eines Reaktionswechselsignals zu bestimmen, eine Minimumfrequenz des Reaktionswechselsignals bei der minimalen Eingangsimpedanz am Eingang der Sendespule zu bestimmen und unter Verwendung der Minimumfrequenz des Reaktionswechselsignals eine Leitfähigkeit des Mediums zu bestimmen.

Eine Ausgestaltung des erfindungsgemäßen induktiven Leitfähigkeitsmessgeräts sieht vor, dass die Steuerungseinrichtung zur Ausführung eines der beschriebenen Verfahren ausgebildet ist.

In einer Ausgestaltung des induktiven Leitfähigkeitsmessgeräts ist vorgesehen, dass die Empfangsspule einen elektrischen Eingang aufweist und der Eingang mit einem elektrischen Abschlusswiderstand abgeschlossen ist. Das bedeutet, dass die Empfangsspule und der Abschlusswiderstand elektrisch parallel geschaltet sind. Dieser Ausgestaltung liegt die Erkenntnis zugrunde, dass durch die Wahl eines Widerstandswerts $R_A$ des Abschlusswiderstands der Leitfähigkeitsmessbereich des induktiven Leitfähigkeitsmessgeräts, welcher eine hohe Empfindlichkeit aufweist, verschiebbar ist. Zur Berechnung des Widerstandswerts des Abschlusswiderstands kann die folgende Formel herangezogen werden:

$$\frac{U_E}{U_S} = \frac{N_E}{N_S} \frac{1}{1 + N_E^2 R_W \left( \frac{1}{R_A} + \frac{1}{j\omega L_E} \right)}$$

In dieser Formel ist $U_E$ ein Empfangswechselsignal in Form einer Spannung über den Eingang der Empfangsspule, $U_S$ ein Sendewechselsignal in Form einer Spannung über den Eingang der Sendespule, $N_E$ eine Anzahl der Windungen der Empfangsspule, Ns eine Anzahl der Windungen der Sendespule, $R_W$ ein Widerstandswert des Mediums, aus welchem die Leitfähigkeit des Mediums unter Verwendung der Geometrie des Mediums bestimmt wird, $L_E$ eine Induktivität der Empfangsspule, $\omega$ eine Kreisfrequenz des Vorgabewechselsignals und j eine imaginäre Einheit.

Die Ausführungen zu dem erfindungsgemäßen Verfahren gelten entsprechend für das induktive Leitfähigkeitsmessgerät und umgekehrt.

Im Einzelnen ist eine Vielzahl von Möglichkeiten gegeben, das erfindungsgemäße Verfahren zum Betreiben eines induktiven Leitfähigkeitsmessgeräts und das induktive Leitfähigkeitsmessgerät auszugestalten und weiterzubilden. Dazu wird verwiesen sowohl auf die den unabhängigen Patentansprüchen nachgeordneten Patentansprüche als auch auf die nachfolgende Beschreibung eines bevorzugten Ausführungsbeispiels in Verbindung mit der Zeichnung. In der Zeichnung zeigt schematisch und abstrahiert

Fig. 1    ein Ausführungsbeispiel eines induktiven Leitfähigkeitsmessgeräts,

Fig. 2    eine Darstellung eines Teils der elektrischen Schaltung des induktiven Leitfähigkeitsmessgeräts aus Fig. 1 und

Fig. 3    einen Ablaufplan eines Ausführungsbeispiels eines Verfahrens zum Betreiben des induktiven Leitfähigkeitsmessgeräts aus Fig. 1.

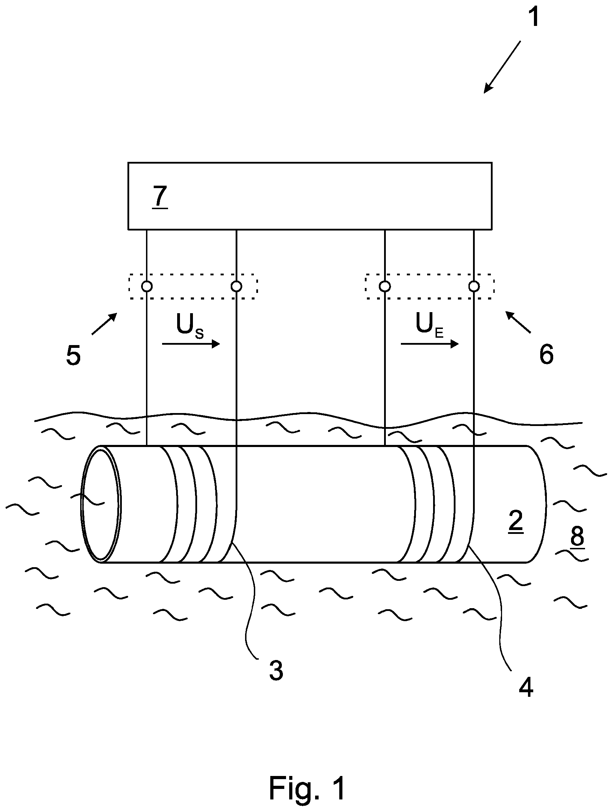

Fig. 1 zeigt das induktive Leitfähigkeitsmessgerät 1. Das induktive Leitfähigkeitsmessgerät 1 weist den hohlzylinderförmigen Träger 2 auf, auf welchem die Sendespule 3 und die Empfangsspule 4 angeordnet sind. Die Sendespule 3 und die Empfangsspule 4 sind auf dem hohlzylinderförmigen Träger 2 angeordnet, indem diese um den hohlzylinderförmigen Träger 2 gewickelt sind, wobei die Sendespule 3 die Anzahl Ns und die Empfangsspule 4 die Anzahl $N_E$ Windungen aufweist. Weiter weist die Sendespule 3 den Eingang 5 und die Empfangsspule 4 den Eingang 6 auf. Das induktive Leitfähigkeitsmessgerät 1 weist darüber hinaus auch die Steuerungseinrichtung 7 auf. Die Steuerungseinrichtung 7 ist zur Steuerung der Sendespule 3 und der Empfangsspule 4 ausgebildet, weshalb die Steuerungseinrichtung 7 auch zum einen mit dem Eingang 5 der Sendespule 3 und zum anderen mit dem Eingang 6 der Empfangsspule 4 elektrisch verbunden ist.

Der hohlzylinderförmige Träger 2 mit der Sendespule 3 und der Empfangsspule 4 ist in das Medium 8 eingetaucht und das induktive Leitfähigkeitsmessgerät 1 ist im Betrieb. Das Medium 8 umgibt den hohlzylinderförmigen Träger 2 und ist auch im Innenraum des hohlzylinderförmigen Trägers 2 vorhanden. Das Medium 8 ist elektrisch leitfähig und koppelt dadurch die Sendespule 3 und die Empfangsspule 4 induktiv miteinander. Da es sich um eine abstrahierte schematische Darstellung des induktiven Leitfähigkeitsmessgeräts 1 handelt, ist ein für gewöhnlich vorhandenes Gehäuse, welches einen unmittelbaren Kontakt der Sendespule 3 und der Empfangsspule 4 mit dem Medium 8 verhindert, hier nicht dargestellt. Durch die Vermeidung eines Kontakts der Sendespule 3 und der Empfangsspule 4 mit dem Medium 8 ist es möglich, das induktive Leitfähigkeitsmessgerät 1 im Gegensatz zu konduktiven Leitfähigkeitsmessgeräten auch in aggressiven und korrosiven Medien wie beispielsweise industriellen Abwässern, Meerwasser und sauren Lösungen einzusetzen, ohne dass die Funktionsfähigkeit des induktiven Leitfähigkeitsmessgeräts 1 eingeschränkt ist. Durch das Gehäuse ist es darüber hinaus auch für hygienische Anwendungen in Prozessen der Branchen Lebensmittel, Getränke und Pharmaka geeignet.

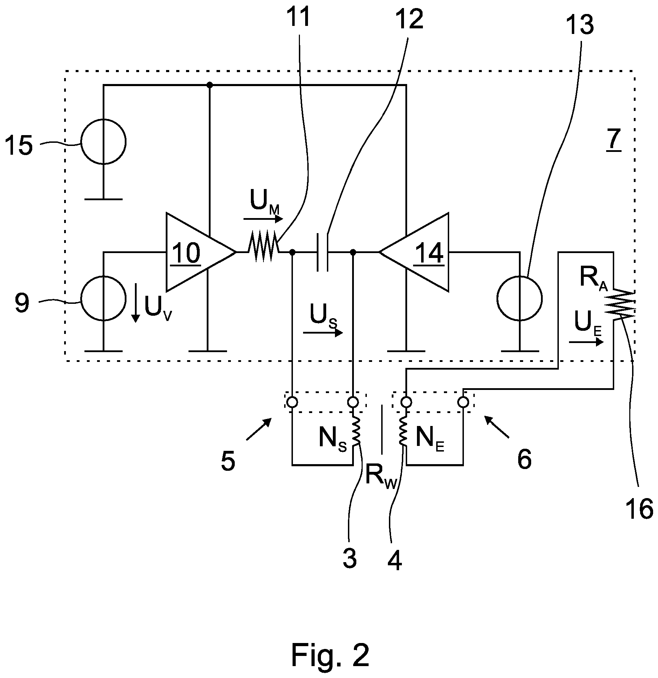

Fig. 2 zeigt eine Darstellung eines Teils der elektrischen Schaltung des induktiven Leitfähigkeitsmessgeräts 1. Die Steuerungseinrichtung 7 ist zur Erzeugung von dem elektrischen Vorgabewechselsignal Uv und zur Zuführung des Vorgabewechselsignals Uv zum Eingang 5 der Sendespule 3 ausgebildet, wobei am Eingang 5 der Sendespule 3 dann das Sendewechselsignal Us anliegt. Dazu weist die Steuerungseinrichtung die Wechselsignalquelle 9 und den ersten Verstärker 10 auf. Die Wechselsignalquelle 9 erzeugt das Vorgabewechselsignal Uv= 1,5 V + 1,4 V sin(ωt), welches aus der konstanten Spannung von 1,5 V und der mit der Kreisfrequenz ω modulierten sinusförmigen Spannung von 1,4 V besteht. Der erste Verstärker 10 hat eine Verstärkung von 1 und dient somit als Puffer-Verstärker. Zwischen dem Verstärker 10 und dem Eingang 5 der Sendespule 3 ist der Messwiderstand 11 angeordnet. Der Kondensator 12 ist elektrisch parallel zur Sendespule 3 geschaltet. Zur Einstellung eines Arbeitspunkts weist die Steuerungseinrichtung 7 darüber hinaus die Gleichsignalquelle 13 und den Verstärker 14 auf. Die Gleichsignalquelle 13 erzeugt eine konstante Gleichspannung von 1,5 V und der zweite Verstärker 14 hat eine Verstärkung von 1 und dient somit ebenfalls als Puffer-Verstärker. Der erste Verstärker 10 und der zweite Verstärker 14 werden von der Versorgungsquelle 15 mit einer Gleichspannung von 3 V versorgt. Der Abschlusswiderstand 16 mit dem Widerstandswert $R_A$ ist elektrisch parallel zur Empfangsspule 4 geschaltet. Der elektrische Widerstandswert des Mediums 8 zwischen der Sendespule 3 und der Empfangsspule 4 beträgt $R_W$. Aus dem elektrischen Widerstandswert $R_W$ des Mediums 8 und der Geometrie des Mediums 8 zwischen der Sendespule 3 und der Empfangsspule 4 wird im Allgemeinen die Leitfähigkeit des Mediums 8 bestimmt.

Die Sendespule 3 und die Empfangsspule 4 sind durch das elektrisch leitfähige Medium 8 - wie bereits erwähnt - induktiv gekoppelt. Die induktive Kopplung erfolgt, indem das in die Sendespule 3 eingespeiste Sendewechselsignal Us in dem Medium 8 Wirbelströme erzeugt, und die Wirbelströme in der Empfangsspule 4 das Empfangswechselsignal $U_E$ induzieren. Somit bewirkt das Vorgabewechselsignal Uv über das Sendewechselsignal Us das Empfangswechselsignal $U_E$.

Die Steuerungseinrichtung 7 ist ausgebildet, die Kreisfrequenz ω des Vorgabewechselsignals Uv in einem Frequenzintervall zu variieren, in dem Frequenzintervall eine frequenzabhängige minimale Eingangsimpedanz am Eingang 5 der Sendespule 3 unter Verwendung des Reaktionswechselsignals $U_M$ über dem Messwiderstand 11 zu bestimmen, eine Minimumfrequenz des Reaktionswechselsignals $U_M$ bei der minimalen Eingangsimpedanz am Eingang 5 der Sendespule 3 zu bestimmen und unter Verwendung der Minimumfrequenz des Reaktionswechselsignals $U_M$ eine Leitfähigkeit des Mediums 8 zu bestimmen. Dabei erzeugt die Wechselsignalquelle 9 das Vorgabewechselsignal Uv, verstärkt der erste Verstärker 10 das Vorgabewechselsignal Uv um den Faktor 1 und bewirkt das Vorgabewechselsignal Uv zum einen über dem Messwiderstand 11 das Reaktionswechselsignal $U_M$ in Form einer Spannung und zum anderen auch das Sendewechselsignal Us in Form einer Spannung.

In diesem Ausführungsbeispiel des induktiven Leitfähigkeitsmessgeräts 1 bilden die Sendespule 3, die Empfangsspule 4, das Medium 8 und der Kondensator 12 einen Schwingkreis mit einer Resonanzfrequenz. Bei dem Schwingkreis handelt es sich um eine Funktion, die für sich genommen keine räumliche Ausgestaltung aufweist. Dabei weisen sowohl die Sendespule 3 als auch die Empfangsspule 4 neben induktiven Komponenten auch parasitäre kapazitive Komponenten auf, die den Schwingkreis beeinflussen. Da die Resonanzfrequenz der Minimumfrequenz entspricht, ist die minimale Eingangsimpedanz am Eingang der Sendespule 3 bei Resonanz des Schwingkreises, also bei Resonanzfrequenz, gegeben, wobei die minimale Eingangsimpedanz mit einer maximalen Amplitude des Reaktionswechselsignals $U_M$ einhergeht. Die Amplitude des Reaktionswechselsignals $U_M$ über dem Frequenzintervall wird zum Beispiel mit einem analogen Lock-In-Verstärker bestimmt und in dem Verlauf der Amplitude über dem Frequenzintervall dann die maximale Amplitude.

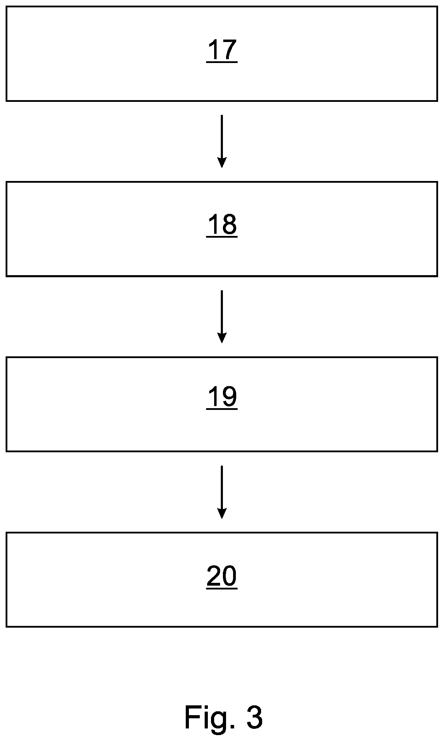

Da das induktive Leitfähigkeitsmessgerät 1 in Betrieb ist, führt die Steuerungseinrichtung 7 das im Ablaufplan in Fig. 3 dargestellte Verfahren mit den folgenden Verfahrensschritten aus.

In einem ersten Verfahrensschritt 17 wird das elektrische Vorgabewechselsignal Uv von der Wechselsignalquelle 9 erzeugt und dem Eingang 5 der Sendespule 3 zugeführt und die Kreisfrequenz ω des Vorgabewechselsignals Uv in einem Frequenzintervall variiert.

In einem zweiten Verfahrensschritt 18 wird in dem Frequenzintervall eine frequenzabhängige minimale Eingangsimpedanz am Eingang 5 der Sendespule 3 unter Verwendung des Reaktionswechselsignals $U_M$ bestimmt.

In einem dritten Verfahrensschritt 19 wird eine Minimumfrequenz des Reaktionswechselsignals $U_M$ bei der minimalen Eingangsimpedanz am Eingang 5 der Sendespule 3 bestimmt.

In einem vierten Verfahrensschritt 20 wird unter Verwendung der Minimumfrequenz des Reaktionswechselsignals $U_M$ eine Leitfähigkeit des Mediums 8 bestimmt.

**Bezugszeichen**

1    Induktives Leitfähigkeitsmessgerät
2    hohlzylinderförmiger Träger
3    Sendespule
4    Empfangsspule
5    Eingang der Sendespule
6    Eingang der Empfangsspule
7    Steuerungseinrichtung
8    Medium
9    Wechselsignalquelle
10   Erster Verstärker
11   Messwiderstand
12   Kondensator
13   Gleichsignalquelle
14   Zweiter Verstärker

15 Versorgungsquelle
16 Abschlusswiderstand
17 Erster Verfahrensschritt
18 Zweiter Verfahrensschritt
19 Dritter Verfahrensschritt
20 Vierter Verfahrensschritt

$N_E$ Anzahl der Windungen der Empfangsspule
$N_S$ Anzahl der Windungen der Sendespule
$R_A$ Widerstandswert des Abschlusswiderstands
$R_W$ Widerstandswert des Mediums
$U_E$ Empfangswechselsignal
$U_M$ Reaktionswechselsignal
$U_S$ Sendewechselsignal
$U_V$ Vorgabewechselsignal

**Patentansprüche**

1. Verfahren zum Betreiben eines induktiven Leitfähigkeitsmessgeräts (1),

   wobei das Leitfähigkeitsmessgerät (1) eine Sendespule (3) und eine Empfangsspule (4) aufweist, die Sendespule (3) einen Eingang (5) aufweist und die Sendespule (3) und die Empfangsspule (4) durch ein elektrisch leitfähiges Medium (8) induktiv miteinander gekoppelt sind
   und wobei ein elektrisches Vorgabewechselsignal (Uv) erzeugt und dem Eingang (5) der Sendespule (3) zugeführt wird,
   **dadurch gekennzeichnet,**
   **dass** eine Frequenz des Vorgabewechselsignals (Uv) in einem Frequenzintervall variiert wird,
   **dass** in dem Frequenzintervall eine frequenzabhängige minimale Eingangsimpedanz am Eingang (5) der Sendespule (3) unter Verwendung eines Reaktionswechselsignals ($U_M$) bestimmt wird,
   **dass** eine Minimumfrequenz des Reaktionswechselsignals ($U_M$) bei der minimalen Eingangsimpedanz am Eingang (5) der Sendespule (3) bestimmt wird
   und **dass** unter Verwendung der Minimumfrequenz des Reaktionswechselsignals ($U_M$) eine Leitfähigkeit des Mediums (8) bestimmt wird.

2. Verfahren nach Anspruch 1, wobei die Sendespule (3), die Empfangsspule (4) und das Medium (8) einen elektrischen Schwingkreis mit einer Resonanzfrequenz bilden, **dadurch gekennzeichnet, dass** bei der Bestimmung von der minimalen Eingangsimpedanz und der Minimumfrequenz die Resonanzfrequenz des Schwingkreises bestimmt wird.

3. Verfahren nach Anspruch 1 oder 2, wobei das Leitfähigkeitsmessgerät (1) einen Messwiderstand (11) am Eingang (5) der Sendespule (3) aufweist, **dadurch gekennzeichnet, dass** als das Reaktionswechselsignal ($U_M$) eine Messspannung über dem Messwiderstand (11) gemessen wird.

4. Induktives Leitfähigkeitsmessgerät (1) mit einer Sendespule (3), einer Empfangsspule (4) und einer Steuerungseinrichtung (7),

   wobei die Sendespule (3) einen Eingang (5) aufweist und die Steuerungseinrichtung (7) zur Erzeugung von einem elektrischen Vorgabewechselsignal (Uv) und zur Zuführung des Vorgabewechselsignals (Uv) zum Eingang (5) der Sendespule (3) ausgebildet ist
   und wobei im Betrieb die Sendespule (3) und die Empfangsspule (4) durch ein elektrisch leitfähiges Medium (8) induktiv miteinander gekoppelt sind
   **dadurch gekennzeichnet,**
   **dass** die Steuerungseinrichtung (7) dazu ausgebildet ist im Betrieb,
   eine Frequenz des Vorgabewechselsignals (Uv) in einem Frequenzintervall zu variieren,
   in dem Frequenzintervall eine frequenzabhängige minimale Eingangsimpedanz am Eingang (5) der Sendespule (3) unter Verwendung eines Reaktionswechselsignals ($U_M$) zu bestimmen,
   eine Minimumfrequenz des Reaktionswechselsignals ($U_M$) bei der minimalen Eingangsimpedanz am Eingang der Sendespule (5) zu bestimmen
   und unter Verwendung der Minimumfrequenz des Reaktionswechselsignals ($U_M$) eine Leitfähigkeit des Mediums (8) zu bestimmen.

5. Induktives Leitfähigkeitsmessgerät (1) nach Anspruch 4, **dadurch gekennzeichnet, dass** die Steuerungseinrichtung (7) zusätzlich zur Ausführung eines Verfahrens nach einem der Ansprüche 2 oder 3 ausgebildet ist.

6. Induktives Leitfähigkeitsmessgerät (1) nach Anspruch 4 oder 5, **dadurch gekennzeichnet, dass** die Empfangsspule (4) einen Eingang (6) aufweist und der Eingang (6) mit einem Abschlusswiderstand (16) abgeschlossen ist.

**Claims**

1. Method for operating an inductive conductivity measuring device (1),

   wherein the conductivity measuring device (1) has a transmitting coil (3) and a receiving coil (4), the transmitting coil (3) has an input (5) and the transmitting coil (3) and the receiving coil (4) are inductively coupled to one another by an electrically conductive medium (8) and wherein an electrical preset alternating signal ($U_V$) is generated and fed to the input (5) of the transmitting coil (3), **characterized in that** a frequency of the preset alternating signal (Uv) is varied in a frequency interval, **that**, in the frequency interval, a frequency-dependent minimum input impedance at the input (5) of the transmitting coil (3) is determined using a response alternating signal ($U_M$), **that** a minimum frequency of the response alternating signal ($U_M$) is determined at the minimum input impedance at the input (5) of the transmitting coil (3), and **that** a conductivity of the medium (8) is determined using the minimum frequency of the response alternating signal ($U_M$).

2. Method according to claim 1, wherein the transmitting coil (3), the receiving coil (4) and the medium (8) form an electrical resonant circuit having a resonant frequency, **characterized in that** in determining the minimum input impedance and the minimum frequency, the resonant frequency of the resonant circuit is determined.

3. Method according to claim 1 or 2, wherein the conductivity measuring device (1) has a measuring resistor (11) at the input (5) of the transmitting coil (3), **characterized in that** a measuring voltage is measured across the measuring resistor (11) as the response alternating signal ($U_M$).

4. Inductive conductivity measuring device (1) having a transmitting coil (3), a receiving coil (4) and a control unit (7),

wherein the transmitting coil (3) has an input (5) and the control unit (7) is designed to generate an electrical preset alternating signal (Uv) and to supply the preset alternating signal (Uv) to the input (5) of the transmitting coil (3) and wherein, during operation, the transmitting coil (3) and the receiving coil (4) are inductively coupled to one another by an electrically conductive medium (8), **characterized in that** the control unit (7) is designed, during operation, to vary a frequency of the preset alternating signal ($U_V$) in a frequency interval, to determine, in the frequency interval, a frequency-dependent minimum input impedance at the input (5) of the transmitting coil (3) using a response alternating signal ($U_M$), to determine a minimum frequency of the response alternating signal ($U_M$) at the minimum input impedance at the input of the transmitting coil (5), and to determine a conductivity of the medium (8) using the minimum frequency of the response alternating signal ($U_M$).

5. Inductive conductivity measuring device (1) according to claim 4, **characterized in that** the control unit (7) is additionally designed for carrying out a method according to any one of claims 2 or 3.

6. Inductive conductivity measuring device (1) according to claim 4 or 5, **characterized in that** the receiving coil (4) has an input (6) and the input (6) is terminated with a terminating resistor (16).

## Revendications

1. Procédé de fonctionnement d'un conductimètre à induction (1),

le conductimètre (1) comportant une bobine émettrice (3) et une bobine réceptrice (4), la bobine émettrice (3) comportant une entrée (5) et la bobine émettrice (3) et la bobine réceptrice (4) étant couplées par induction l'une à l'autre par un milieu électriquement conducteur (8) et un signal électrique alternatif par défaut ($U_V$) étant généré et amené à l'entrée (5) de la bobine émettrice (3), **caractérisé en ce que** une fréquence du signal alternatif par défaut ($U_V$) est modifiée dans un intervalle de fréquence, dans l'intervalle de fréquence, une impédance d'entrée minimale dépendant de la fréquence est déterminée à l'entrée (5) de la bobine émettrice (3) à l'aide d'un signal de réaction alternatif ($U_M$), une fréquence minimale du signal de réaction alternatif ($U_M$) est déterminée, pour l'impédance d'entrée minimale, à l'entrée (5) de la bobine émettrice (3), et une conductivité du milieu (8) est déterminée à l'aide la fréquence minimale du signal de réaction alternatif ($U_M$).

2. Procédé selon la revendication 1, la bobine émettrice (3), la bobine réceptrice (4) et le milieu (8) formant un circuit électrique résonnant ayant une fréquence de résonance, **caractérisé en ce que** la fréquence de résonance du circuit résonnant est déterminée lors de la détermination de l'impédance d'entrée minimale et de la fréquence minimale.

3. Procédé selon la revendication 1 ou 2, le conductimètre (1) comportant une résistance de mesure (11) à l'entrée (5) de la bobine émettrice (3), **caractérisé en ce qu'**une tension de mesure aux bornes de la résistance de mesure (11) est mesurée comme signal de réaction alternatif ($U_M$).

4. Conductimètre à induction (1) comprenant une bobine émettrice (3), une bobine réceptrice (4) et un dispositif de commande (7),

la bobine émettrice (3) comportant une entrée (5) et le dispositif de commande (7) étant conçu pour générer un signal électrique alternatif par défaut ($U_V$) et pour fournir le signal alternatif par défaut ($U_V$) à l'entrée (5) de la bobine émettrice (3),

et, en fonctionnement, la bobine émettrice (3) et la bobine réceptrice (4) étant couplées par induction l'une à l'autre par le biais d'un milieu électriquement conducteur (8),

**caractérisé en ce que**

le dispositif de commande (7) est conçu en fonctionnement

pour faire varier une fréquence du signal alternatif par défaut ($U_V$) dans un intervalle de fréquence,

pour déterminer dans l'intervalle de fréquence une impédance d'entrée minimale dépendant de la fréquence à l'entrée (5) de la bobine émettrice (3) à l'aide d'un signal de réaction alternatif ($U_M$),

pour déterminer une fréquence minimale du signal de réaction alternatif ($U_M$) pour l'impédance d'entrée minimale à l'entrée de la bobine émettrice (5) et

pour déterminer une conductivité du milieu (8) à l'aide de la fréquence minimale du signal de réaction alternatif ($U_M$).

5. Conductimètre à induction (1) selon la revendication 4, **caractérisé en ce que** le dispositif de commande (7) est en outre conçu pour mettre en œuvre un procédé selon l'une des revendications 2 et 3.

6. Conductimètre à induction (1) selon la revendication 4 ou 5, **caractérisé en ce que** la bobine réceptrice (4) comporte une entrée (6) et l'entrée (6) se termine par une résistance de terminaison (16).

Fig. 1

Fig. 2

```
┌─────────────────────────────────────┐
│                                     │
│                 17                  │
│                                     │
└─────────────────────────────────────┘
                   │
                   ▼
┌─────────────────────────────────────┐
│                                     │
│                 18                  │
│                                     │
└─────────────────────────────────────┘
                   │
                   ▼
┌─────────────────────────────────────┐
│                                     │
│                 19                  │
│                                     │
└─────────────────────────────────────┘
                   │
                   ▼
┌─────────────────────────────────────┐
│                                     │
│                 20                  │
│                                     │
└─────────────────────────────────────┘
```

Fig. 3